(19) **Europäisches Patentamt**
**European Patent Office**
**Office européen des brevets**

(11) **EP 0 746 870 B2**

(12) # NEW EUROPEAN PATENT SPECIFICATION
After opposition procedure

(45) Date of publication and mention
of the opposition decision:
**25.06.2014 Bulletin 2014/26**

(45) Mention of the grant of the patent:
**29.11.2000 Bulletin 2000/48**

(21) Application number: **94911651.1**

(22) Date of filing: **16.03.1994**

(51) Int Cl.:
*G21K 5/10* (2006.01)   *B61B 10/02* (2006.01)
*B65B 55/16* (2006.01)   *A23L 3/26* (2006.01)
*H01J 37/30* (2006.01)   *G01N 21/00* (2006.01)

(86) International application number:
**PCT/US1994/002962**

(87) International publication number:
**WO 1994/022162 (29.09.1994 Gazette 1994/22)**

(54) **IRRADIATION SYSTEM UTILIZING CONVEYOR-TRANSPORTED ARTICLE CARRIERS**

BESTRAHLUNGSSYSTEM MIT FOERDEREINRICHTUNG FUER ARTIKELTRAEGERELEMENTE

SYSTÈME D'IRRADIATION UTILISANT DES SUPPORTS D'ARTICLES TRANSPORTÉS PAR CONVOYEUR

(84) Designated Contracting States:
**AT BE CH DE DK ES FR GB GR IE IT LI LU NL PT SE**

(30) Priority: **19.03.1993 US 33392**

(43) Date of publication of application:
**11.12.1996 Bulletin 1996/50**

(60) Divisional application:
**00100048.8 / 0 999 556**
**01200709.2 / 1 115 121**

(73) Proprietor: **THE TITAN CORPORATION**
**San Diego, California 92121-1002 (US)**

(72) Inventors:
• **PECK, Richard, O.**
**Lakewood, CO 80215 (US)**
• **PAGEAU, Gary, Michael**
**Englewood, CO 80112 (US)**
• **WILLIAMS, Colin, Brian**
**California 92037 (US)**

• **ALLEN, John, Thomas**
**San Diego, CA 92130 (US)**
• **WICKERSHAM, Bernard, G.**
**Parker, CO 80134 (US)**
• **BISGROVE, Leonard, C.**
**Evergreen, CO 80439 (US)**
• **SELLERS, Bruce, D.**
**Aurora, CO 80012 (US)**

(74) Representative: **Dempster, Benjamin John Naftel et al**
**Withers & Rogers LLP**
**4 More London Riverside**
**London**
**SE1 2AU (GB)**

(56) References cited:
**EP-A1- 0 237 299     DE-A1- 3 303 370**
**GB-A- 962 477       US-A- 3 564 241**
**US-A- 4 584 944      US-A- 4 653 630**
**US-A- 4 852 138      US-A- 5 038 911**

EP 0 746 870 B2

**Description**

**BACKGROUND OF THE INVENTION**

The present invention generally pertains to irradiation systems that utilize a conveyor for transporting articles past a radiation source and is particularly directed to conveyor systems that transport article carriers past a given location and to the article carriers used therewith.

Irradiation systems are used for irradiating articles, such as foodstuffs, food utensils, medical devices, consumer goods, cosmetics, and waste products and their containers, with high energy electromagnetic radiation, such as an electron beam, X-rays and microwaves, for the purpose of sterilizing such articles.

US-A-3 564 241 describes irradiation system apparatus, including a process conveyor for transporting article carriers past a radiation source at a first speed; a transport conveyor for transporting the article carriers from a loading area at a second speed that differs from said first speed; and a load conveyor for transporting the article carriers from the transport conveyor to position the article carriers on the process conveyor in such a manner that when the article carriers are positioned on the process conveyor there is a predetermined separation distance between adjacent positioned article carriers. After a first side of the articles carried by a given article carrier has been irradiated, the article carrier is reoriented for retransportation past the radiation source by the process conveyor so that a second side of the carried articles is irradiated.

US-A-4 852 138 describes irradiation system apparatus including a plurality of conveyor lines for transporting article carriers past radiation sources in such a manner that both sides of articles carried by the article carriers are irradiated.

**SUMMARY OF THE INVENTION**

The present invention provides irradiation system apparatus according to claim 1.

Suitably the article carriers have a maximum length and the transport conveyor Is an overhead power-and-free conveyor having a movable claim and dogs that are attached to the chain at intervals greater than the maximum article carrier length for engaging the article carriers to transport the article carriers, wherein a said dog is disengaged from a said article carrier when the said article carrier is restrained from movement by at least a predetermined restraining force, characterised by

an escapement located next to the transport conveyor for restraining said article carriers with at least said predetermined restraining force at a release point from which a said article carrier is transported from the transport conveyor by the load conveyor; and

a controller coupled to the load conveyor and adapted in accordance with the speed of the process conveyor for causing the load conveyor to engage the said restrained article carrier for transport by the load conveyor and to override the restraint applied by the escapement at a release time that results in the said article carrier being positioned on the process conveyor at the predetermined separation distance from another said article carrier next previously positioned on the process conveyor after the load conveyor transports the said article carrier from the transport conveyor to the process conveyor at said varied speed.

Preferably each carrier includes end members as defined by the direction in which the article carriers are transported by the process conveyor,

characterised by the end members having supporting struts disposed on the outside of said end members, with the struts being disposed differently on one end member than on the other end member so that the struts on one said article carrier cannot contact the struts on another said article carrier positioned adjacent thereto on the process conveyor with the same lateral orientation as the one said article carrier notwithstanding the end-to-end orientation of the article carriers, whereby the article carriers can be positioned closer together than would be possible if the struts on one said article carrier could contact the struts on another said article carrier when said article carriers are positioned adjacent each other on the process conveyor with said same lateral orientation.

In one preferred arrangement the radiation source is disposed along an approximately horizontal axis and the process conveyor is disposed in relation to the radiation source such that articles carried by article carriers having a first horizontal orientation receive radiation impinging upon a first side of the articles; and a reroute conveyor is coupled to the process conveyor for reorienting the article carriers for retransportation past the radiation source by the process conveyor so that a second side of the said carried articles opposite to said first side receives impinging radiation from the radiation source,

characterised by means for detecting whether or not a said article carrier transported from the process conveyor has been reoriented; and

means coupled to the detecting means for routing said article carrier to the reroute conveyor when the detecting means detect that said article carrier has not been reoriented and for routing said article carrier for transportation to an unloading area when the detecting means detect that said article carrier has been rerouted.

Suitably the radiation source is adapted for scanning articles carried by the article carriers being transported by the process conveyor with a radiation beam that scans the transported articles at a given rate in a plane perpendicular to the direction of transport, characterised by

means adapted for measuring a speed at which said article carrier is being transported past the radiation source; means adapted for processing said measurements to determine whether said article carrier transport speed is outside of a given range; and means responsive to said processing means for interrupting both radiation from said radiation source and said transport by the process conveyor when the processing means determine that the article carrier transport speed is outside of said given range.

Additional features of the present invention are specified in the claims and are described in relation to the detailed description of the preferred embodiments.

## BRIEF DESCRIPTION OF THE DRAWING

Figure 1 illustrates a preferred embodiment of the irradiation systems of the present invention, with the ceiling and the upper portion of the walls of the housing not being shown in order to better illustrate the irradiation system contained therein.

Figure 2 illustrates a portion of the system illustrated in Figure 1, as viewed from a different perspective.

Figure 3A is a side plan view of an article carrier included in the system illustrated in Figures 1 and 2.

Figure 3B is an end plan view of the article carrier of Figure 3A supported from an overhead track.

Figure 3C is a top plan view of the article carrier of Figures 3A and 3B.

Figure 4 is a top plan view of a number of article carriers being supported by a portion of the transport conveyor prior to transport by the load conveyor and of a number of article carriers being transported by the process conveyor after having been transported by the load conveyor.

Figure 5A is a end plan view of the load conveyor and a portion of the process conveyor shown in Figure 4.

Figure 5B is a side plan view of the load conveyor and a portion of the process conveyor shown in Figure 4.

Figure 6A is a top plan view of the process conveyor and an overlapping portion of the load conveyor included in the system illustrated in Figures 1 and 2.

Figure 6B is a side plan view of the process conveyor shown in Figure 6A with the portion of the transport conveyor disposed above the process conveyor and a number of article carriers being supported and transported by the process conveyor also being shown.

Figure 7A is a characteristic curve of the speed of the load conveyor as a function of time.

Figure 7B is a characteristic curve of the distance over which each article carrier is transported by the load conveyor as a function of time, with Figure 7B having the same time scale as Figure 7A.

Figure 8A is a top plan view of a gear rack mounted adjacent an reroute conveyor in the conveyor system illustrated in Figure 1 for engagement with the article carrier to rotationally reorient the article carrier, with internal portions of the rack being shown by dashed lines.

Figure 8B is an end plan view of the gear rack shown in Figure 8A in combination with an article carrier supported from an overhead track with only the top portion of the article carrier being shown.

Figure 9 is a diagram of the tubes of the power-and-free overhead transport conveyor in the loading and unloading area for the conveyor system illustrated in Figures 1 and 2 together with the system controller and the chain drive and tensioning chain means for the powered portion of the transport conveyor.

## DETAILED DESCRIPTION

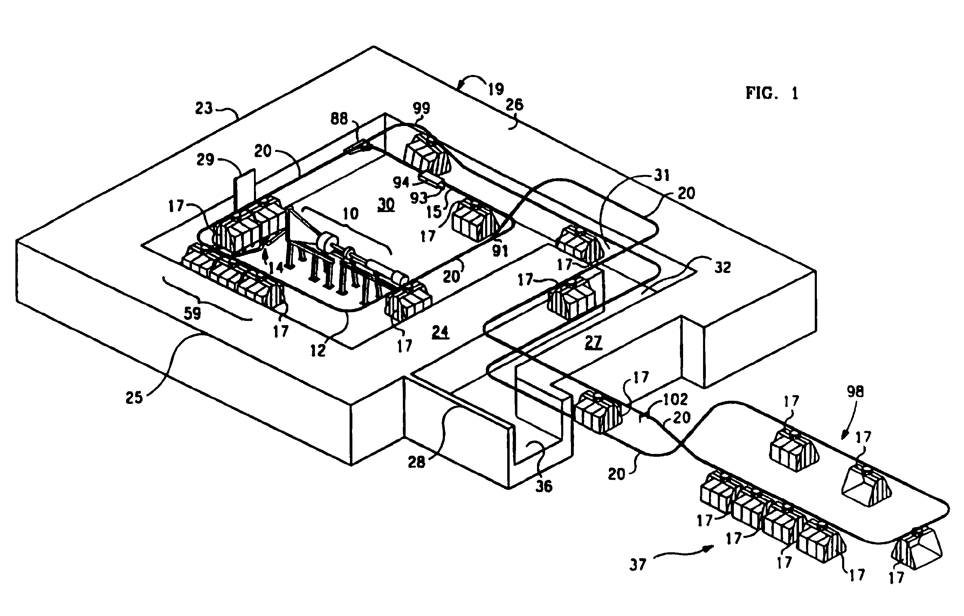

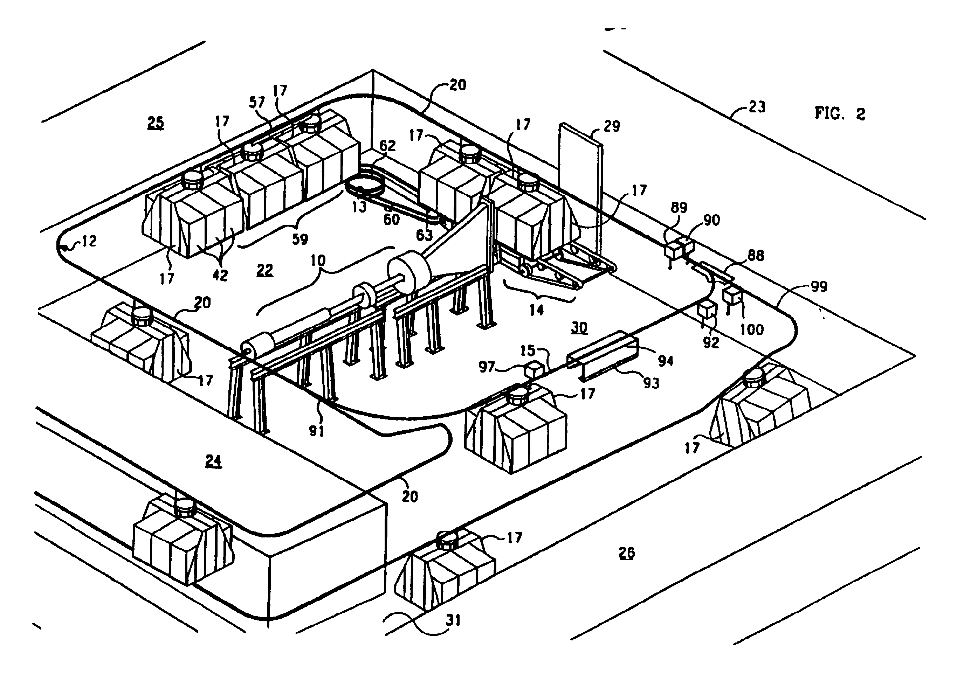

Referring to Figures 1 and 2, a preferred embodiment of the radiation system of the present invention includes a radiation source 10, a conveyor system that includes an overhead transport conveyor 12, a load conveyor 13, a process conveyor 14 and a reroute conveyor 15, a plurality of article carriers 17, a system control circuit 18 and a housing 19. The system controller 18 is located outside the housing 19.

The radiation source 10 is a 10-million-electron-volt linear accelerator that provides an electron beam for irradiating articles transported past the radiation source 10 by the process conveyor 14. The radiation source 10 is disposed along an approximately horizontal axis and scans articles in the article carriers 10 being transported by the process conveyor 14 with a radiation beam that scans the transported articles at a given rate in a plane perpendicular to the direction of transport.

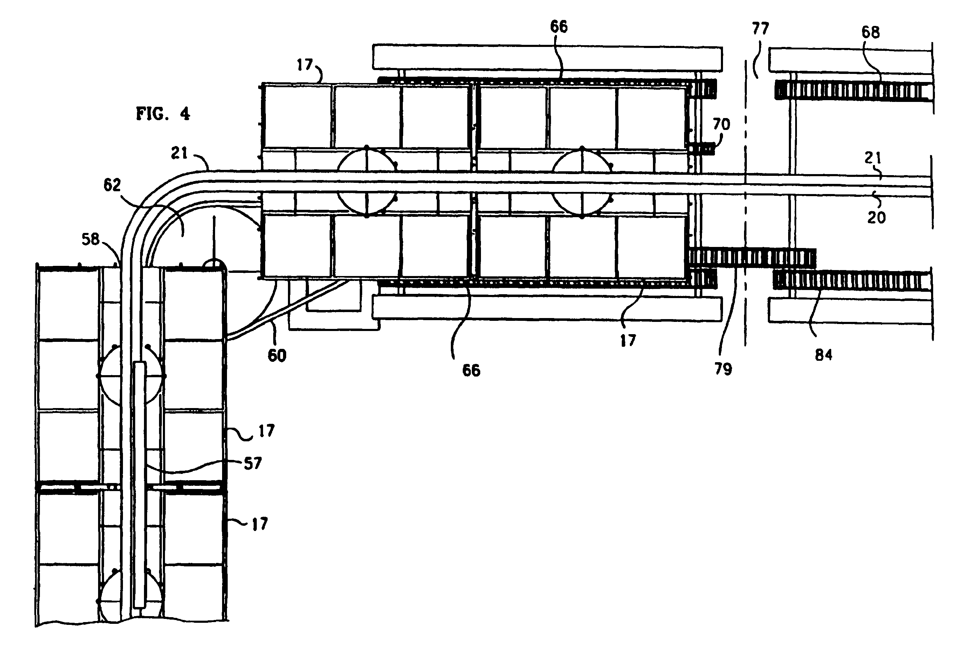

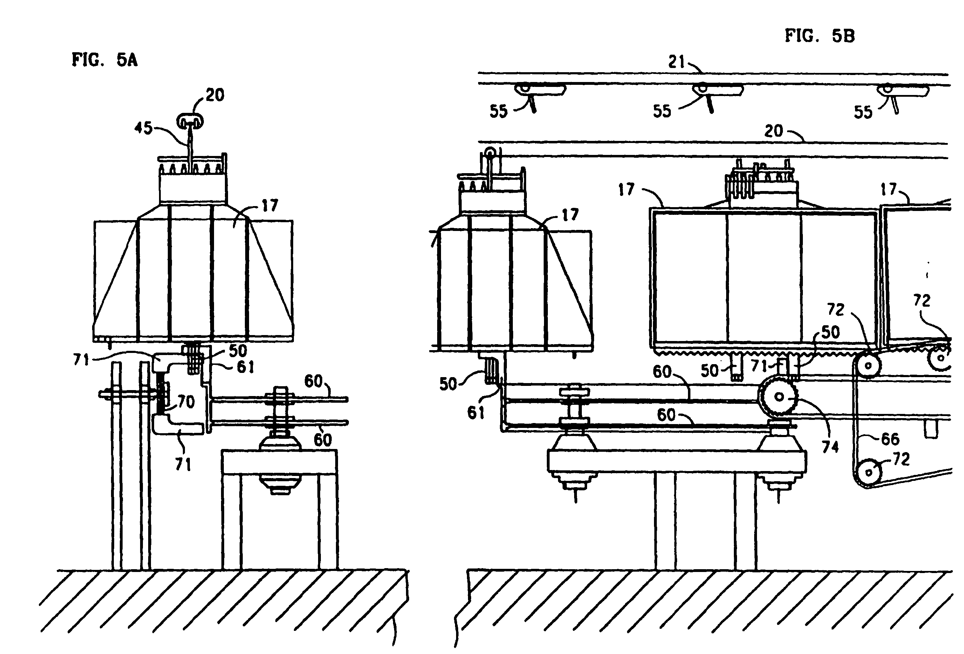

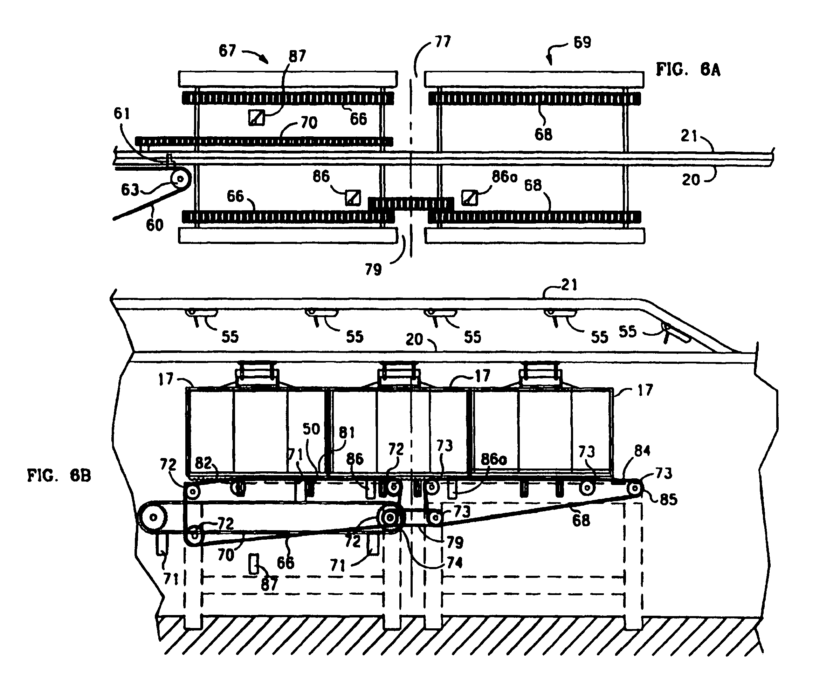

The transport conveyor 12 is an overhead power-and-free conveyor that includes a track 20 and a slotted tube 21 (Figures 4, 5B, 6B and 9) containing a continuously driven chain 54 with dogs 55 attached thereto disposed adjacent the track 20 except in the loading area 34 and the unloading area 98, where the track is disposed along a different path from the tube 21, and except where the track 20 passes over the load conveyor 13 and the process conveyor 14, where the tube 21 is elevated In relation to the track 20. The track 20 also is a slotted tube.

The use of a power-and-free conveyor as the transport conveyor 12 enables different article carriers 17 to be transported throughout the conveyor system at different required speeds in accordance with where in the conveyor system the article carriers 17 are being transported, because such transport in different parts of the system can either be powered by and thus at the speed of the transport conveyor 12, or free of the power of the transport conveyor and thus at a speed independent of the speed of the transport conveyor 12 while maintaining contact with the track 20 of the transport conveyor 12 so that the transport of each article carriers 17 by the transport conveyor 12 can be resumed after an interval during which the article carrier 17 is not being transported by the transport conveyor 12.

The housing 19 includes a floor 22, a ceiling (not shown) and set of walls 23, 24, 25, 26, 27, 28, all of which are made of radiation shielding material, such as reinforced concrete. A beam stop 29 is disposed on the opposite side of the process conveyor 14 from the radiation source 10. The housing 19 defines a process chamber 30 in which the radiation source 10 and a portion of the transport conveyor 12 are disposed, an entry 31 into the chamber 30 for the transport conveyor 12 and a passageway 32 for the transport conveyor 12 leading to the entry 31 into the chamber 30. Another portion of the transport conveyor 12 is located at a loading area 34 outside the set of walls 23, 24, 25, 26, 27, 28 and shielded by the set of walls 23, 24, 25, 26, 27, 28 from radiation emitted by the radiation source 10.

A first wall 23 is disposed in front of the radiation source 10 for absorbing radiation received directly from the radiation source 10. The first wall 23 is approximately 3 m (ten feet) thick.

A second wall 24 is disposed behind the radiation source 10 and opposite the first wall 23 for absorbing radiation from the radiation source 10 that is reflected within the process chamber 30. The second wall 24 is approximately 2,13 m (seven feet) thick.

A third wall 25 is disposed on one side of the radiation source 10 and connects the first wall 23 and the second wall 24 for absorbing the reflected radiation. The third wall 25 is approximately 2,13 m (seven feet) thick.

A fourth wall 26 is disposed on the other side of the radiation source 10 for absorbing the reflected radiation. The fourth wall 26 is connected to the first wall 23 and is separated from the second wall 24 to define the entry 31 into the process chamber 30 for the transport conveyor 12. A fourth wall 26 is approximately 2,13 m (seven feet) thick.

A fifth wall 27 is connected to the fourth wall 26 and disposed in relation to the second wall 24 for defining the passageway 32 for the transport conveyor 12 between the second wall 24 and the fifth wall 27 and for absorbing said reflected radiation that is further reflected through the entry 31 from the process chamber 30. The fifth wall is approximately seven feet thick adjacent the entry 31 and approximately three feet thick adjacent the passageway 32.

A sixth wall 28 is connected to the second wall 24 and disposed in relation to the fifth wall 27 for defining an opening 36 into the passageway 32 for the transport conveyor 12 between the fifth wall 27 and the sixth wall 28 and for absorbing said reflected radiation that is further reflected through the passageway 32 from the process chamber 30. The sixth wall 28 is approximately 30 cm (one foot) thick.

To minimize the size of the process chamber 30, and thus the amount of shielding material required, the transport conveyor tack 20 has several 90-degree turns, including one shortly prior to where the article carriers 17 are positioned on the process conveyor 14.

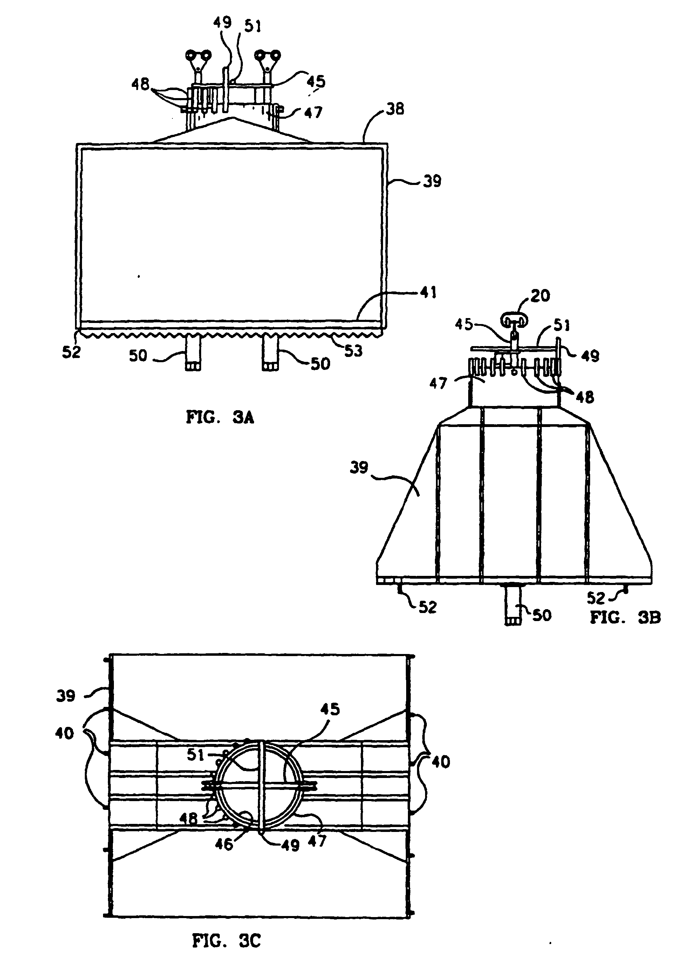

Referring to Figures 3A, 3B and 3C an individual article carrier 17 includes a top cross member 38, end members 39 as defined by the direction in which the article carrier 17 is transported by the process conveyor 14, with the end members 39 having supporting struts 40 on the outside surfaces of the end members 39, and a platform 41 for receiving the articles to be sterilized or cartons 42 containing such articles, as shown in Figures 1 and 2.

Individual article cartons 42 may be so dimensioned that the cross-beam exposure space within the article carrier 17 is efficiently utilized. When the articles to be sterilized are elongated, the cartons 42 are dimensioned to contain the elongated articles in such an orientation that when the article carrier 17 is transported past the radiation source 10, the elongated articles are irradiated approximately normal to the long dimension of the elongated articles to thereby achieve optimum article sterility together with optimum article throughput efficiency with respect to utilization of the energy of the radiation beam emitted by the radiation source 10 as the articles are transported past the radiation source 10.

An individual article carrier 17 further includes a trolley 45, an inner collar 46 that is non-rotatably attached to the trolley 45, an outer collar 47 that is attached to the top cross member 38 and rotatably coupled to the inner collar 46, a series of pins 48 attached to the outer collar 47, a striker tab 49 extending vertically from one side of the outer collar 47, a pair of lugs 50 extending downwardly from the platform 41 along the longitudinal axis of the article carrier 17, a bar 51 attached to the trolley 45 and a pair of members 52 attached to the bottom of the platform 41 on opposite lateral sides of the platform 41, wherein each member 52 has a a serrated edge 53 extending downwardly from the platform 41.

The trolley 45 rides on the transport conveyor track 20 and rotatably suspends the article carrier 17 from the transport conveyor track 20.

The striker tab 49 extends vertically from one side of the article carrier 17 to enable a determination to be made as to whether or not the carrier 17 has a predetermined rotational orientation in relation to the process conveyor 14.

The respective functions of the other elements of the article carrier 17 are described later herein with reference to other components of the irradiation system with which these elements functionally cooperate.

Referring to Figure 1, 2, 4, 5A, 5B, 6A and 6B, the process conveyor 14 supports the article carriers 17 and transports the article carriers 17 past the radiation source at a first speed: and the transport conveyor 12 transports the article carriers 17 from the loading area 34 at a second speed that differs from the first speed. In order to most efficiently utilize the energy of the radiation beam emitted by the radiation source 10, the spacing between the article carriers 17 as they are transported by the process conveyor 14 past the radiation source 10 must be as small as practically possible. To achieve consistent close spacing between the article carriers 17 as the article carriers are being transported by the process conveyor 14, the load conveyor 13 is adapted for engaging the article carriers 17 and for transporting the engaged article carriers 17 from the transport conveyor 12 to the process conveyor 14 at a speed that is varied during said transport by the load conveyor 13 in such a manner that the article carriers 17 are so positioned on the process conveyor 14 that there is a predetermined separation distance, such as 2,54 cm (one inch) between adjacent positioned article carriers 17. With 2,54 cm (one-inch) spacing between article carriers 17 having a length of 101 cm (forty inches) and with end members 39 of 1,27 cm (one-half-inch) thickness, the space between the interiors of adjacent positioned article carriers is approximately 5 cm (two inches) whereby the efficiency of radiation beam energy utilization may be as high as 95 percent.

The article carrier struts 40 are disposed differently on one end member 39 than on the other end member 39 so that the struts 40 on one article carrier 17 cannot contact the struts 40 on another article carrier 17 positioned adjacent thereto on the process conveyor 14 with the same lateral orientation as the one article carrier 17 notwithstanding the end-to-end orientation of the article carriers 17; whereby the article carriers 17 can be positioned closer together on the process conveyor 14 than would be possible if the struts 40 on one article carrier 17 could contact the struts 40 on another article carrier 17 when the article carriers 17 are positioned adjacent each other on the process conveyor 14 with the same lateral orientation.

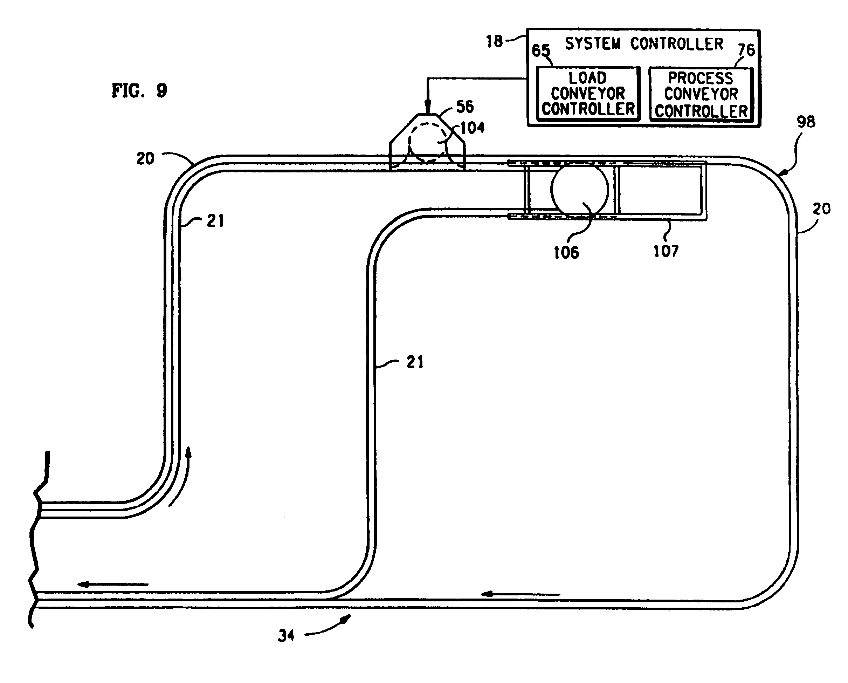

The transport conveyor 12 further includes a movable chain 54 within the slotted tube 21 adjacent the track 20 and dogs 55 attached to the chain 54 at predetermined intervals. The chain 54 is continuously driven through the tube 21. The chain 54 is continuously driven by a drive motor 56 (Figure 9) located outside the housing 19. Operation of the drive motor 56 is controlled by the system controller 18.

The separation distance between adjacent dogs 55 is greater than the maximum article carrier length. As the chain 54 is being driven through the track 20, a dog 55 engages the bar 51 attached to the trolley 45 of an article carrier 17 to thereby pull the article carrier 17 along the path of the transport conveyor track 20.

An escapement 57 is located next to the transport conveyor 12 for restraining the leading edge of an article carrier 17 at a release point 58 at the beginning of the 90-degree turn in the transport conveyor track 20 adjacent a staging area 59 from which the article carriers 17 are transported from the transport conveyor 12 by the load conveyor 13. The speed of movement of the transport conveyor chain 54 must be high enough to ensure an uninterrupted supply of article carriers 17 at the staging area 59, but not so high that the carriers 17 are damaged by contact with one another as they accumulate at the staging area 59. The escapement 57 contacts the bar 51 of the article carrier 17 to restrain further movement of the article carrier 17 with at least a predetermined restraining force until released by the escapement 57. The predetermined restraining force is large enough to cause the transport conveyor dog 55 to disengage from the trolley 45 of the restrained article carrier 17 as the continuously driven transport conveyor chain 54 moves the attached dog 55 past the staging area 59. The number of article carriers 17 being transported by the transport conveyor 12 throughout the irradiation system ideally is such in relation to the relative speeds of the transport conveyor 12 and the process conveyor 14 that the article carriers 17 accumulate behind the article carrier 17 restrained by the escapement 57. The predetermined restraining force provided by the escapement 57 also is large enough to cause the transport conveyor dogs 55 to disengage from the trolleys 45 of the accumulated article carriers 17 as the continuously driven transport conveyor chain 54 moves the attached dogs 55 past the staging area 59. The chain 54 is elevated from the track 20 between the release point 58 and the other side of the process conveyor 14 so as not to be able to again engage a trolley 45 of an article carrier 17 until the article carrier 17 has been transported past the radiation source 10 by the process conveyor 14.

The escapement 57 provides compound control of the movement of the article carriers 17. As one carrier 17 is released, the following carrier 17 is stopped by the escapement 57 until the one carrier 17 has moved beyond the escapement 57. When the escapement 57 is engaged so as to stop the next carrier 17 at the release point 58, the escapement stop for the following carrier 17 releases so the over-riding transport conveyor dog 55 can engage the trolley 45 of the following carrier to transport the following carrier 17 to the release point 58.

The load conveyor 13 includes a pair of chains 60, a latching dog 61 attached to the chains 60, a first sprocket wheel 62 and a second sprocket wheel 63 that are coupled to the chains 60 for driving the chains 60 in a horizontal plane, and a drive motor (not shown) coupled to the second sprocket wheel 63. The speed of the drive motor is controlled by a load conveyor controller 65, which is a part of the system controller 18 (Figure 9) located outside the housing 19. The first sprocket wheel 62 has a large pitch radius which corresponds to the radius of the 90-degree turn corresponding to the 90-degree turn in the transport conveyor track 20 shortly prior to where the article carriers 17 are positioned on the process conveyor 14.

The latching dog 61 is disposed for engaging the leading lug 50 attached to the bottom of the article carrier 17. The latching dog 61 engages the leading lug 50 during both acceleration and deceleration of the article carrier 17 while the article carrier is being moved by the load conveyer 13 from the release point 58 to the process conveyor 14. The latching dog 61 disengages from the leading lug 50 when the latching dog 61 contacts a cam (not shown) before the latching dog 61 begins to move around the second sprocket wheel 63.

The overhead track 20 of the transport conveyor 12 extends over the load conveyor 13 and the process conveyor 14 and guides the transport of the article carriers 17 so that the article carriers 17 are consistently placed on the process conveyor 14 in a predetermined position in relation to the radiation source 10.

The process conveyor 14 includes a first pair of Hyvo chains 66 within a first portion 67 of the process conveyor 14, a second pair of Hyvo chains 68 within a second portion 69 of the process conveyor 14, an auxiliary chain 70, three evenly spaced dogs 71 attached to the auxiliary chain 70, a first set of sprocket wheels 72 for driving the first pair of Hyvo chains 66, a second set of sprocket wheels 73 for driving the second pair of Hyvo chains 68, third set of sprocket wheels 74 for driving the auxiliary chain 70 and a servo drive motor (not shown) coupled to one each of the sprocket wheels 72, 74, which are on a common drive shaft. The speed of the servo drive motor is controlled by a process conveyor controller 76 (Figure 9), which is a part of the system controller 18 located outside the housing 19.

The Hyvo chains 66, 68 of the process conveyor 14 support the article carriers 17 and transport the article carriers 17 past the radiation source 10 as the Hyvo chains 66, 68 are being driven by the servo motor.

There is a gap 77 between the first portion 67 of the process conveyor 14 and the second portion 69 of the process conveyor 14. The gap 77 is located where the radiation beam emitted by the radiation source 10 scans the articles in the article carriers 17 transported past the radiation source 10 by the process conveyor 14 so that the radiation beam does not directly impinge upon the Hyvo chains 66, 68. The first process conveyor portion 67 is coupled to the second process conveyor portion 69 by another chain 79, which is driven by sprocket wheels respectively included in the first set of sprocket wheels 72 and the second set of sprocket wheels 73. The other chain 79 is located beneath the scan of the beam emitted from the radiation source 10. The first pair of Hyvo chains 66, the second pair of Hyvo chains 68, the auxiliary chain 70 and the other chain 79 are all driven at the same speed in response to power provided by the servo motor to one of the sprocket wheels 72 of the first set.

After the load conveyor 13 initially positions the leading edge of an article carrier 17 onto the first portion 67 of the process conveyor 14, one of the three dogs 71 attached to the auxiliary chain 70 engages the trailing side of the leading lug 50 on the bottom of the carrier 17 just before the latching dog 61 of the transport conveyor moves around the second sprocket wheel 63 and disengages from the leading carrier lug 50.

The first process conveyor portion 67 includes a level section 81, within which the article carriers 17 are supported by the first pair of Hyvo chains 66 while being transported to and past the radiation source 10 by movement of the first pair of Hyvo chains 66, and an upwardly inclined section 82 onto which the article carriers 17 transported by the load conveyor 13 are positioned on the process conveyor 14 so that the article carriers 17 are elevated as they are positioned on the process conveyor 14 so that the article carriers 17 are not supported by the overhead transport conveyor 12 while being transported by the process conveyor 14.

The auxiliary chain dog 71 continues to engage the the leading lug 50 on the bottom of the carrier 17 in order to transport the article carrier at the speed of the process conveyor 14 until the carrier is fully supported by the Hyvo chains 66 of the first process conveyor portion 67. The dog 71 disengages from the leading lug 50 when it is turned away from the leading lug 50 by downward movement of the auxiliary chain 70 adjacent the gap 77.

The gap 77 is of such relatively small breadth that support and transport of the article carrier 17 is transferred from the first process conveyor portion 67 to the second process conveyor portion 69 as the article carrier 17 is being transported past the radiation source 10.

The second process conveyor portion 69 includes a level section 84, within which the article carriers 17 are supported by the second pair of Hyvo chains 68 while being transported past and from the radiation source 10 by movement of the second pair of Hyvo chains 66. As an article carrier 17 leaves the the second process conveyor section 69, the article carrier 17 is again supported by the track 20 of the overhead transport conveyor 12.

Above the discharge end 85 of the second process conveyor section 69, the chain 54 of the transport conveyor 12 descends to the same level as the track 20 of the transport conveyor 12 so that an article carrier 17 leaving the second process conveyor section 69 can be engaged by a transport conveyor dog 55 attached to the chain 54. When the article carrier 17 leaving the second process conveyor section 69 is engaged by a transport conveyor dog 55, the so engaged article carrier 17 is transported from the process conveyor 14 at a speed that is greater than the process conveyor speed.

The speed of process conveyor 14 is adjustable over a relatively large range in order to subject the articles carried by the article carriers 17 to a prescribed radiation dosage within a range of radiation dosages. In all cases, the speed of the transport conveyor chain 54 exceeds the speed of the process conveyor 14. In the preferred embodiment the speed of movement of the transport conveyor chain 54 is a constant.

The process conveyor controller 76 controls the servo drive motor for the process conveyor 14 by internal data processing based on quadrature format encoder counts. The controller 76 uses a proportional integrated differential (PID) loop in order to reduce the difference between a predetermined speed that is proportional to selected process conveyer drive speed and the actual servo motor armature speed (as indicated by the encoder counts) to be as close to zero as possible. By selecting an encoder with sufficient resolution and programmable error tolerances, drive speed errors are held within prescribed limits.

The system controller 18 monitors the accuracy of the speed control achieved by the PID loop by passing the process conveyor drive encoder speed output of the process conveyor controller 76 to a programmable logic controller (PLC), which at each control cycle update period compares this value to a set point speed commanded by the PLC program. This method verifies that the PLC instructed speed value is being achieved. Should the monitored speed fall outside a predetermined range, the system controller 18 turns off all of the conveyors 12, 13, 14, 15 and the radiation source 10 to interrupt transport of the article carrier 17 past the radiation source 10 by the process conveyor 14 and to interrupt the emission of radiation by the radiation source 10.

The system controller 18 also continuously measures the actual speed at which the article carrier 17 is being transported past the radiation source 10. Such article transport speed may differ from the process conveyor speed if there is slippage between the article carrier 17 and the process conveyor 14 and/or if movement of the carrier 17 is impeded by extraneous means. Limit switches 86 and 86a are disposed respectively adjacent one the Hyvo chains 66, 68 in each portion 67, 69 of the process conveyor 14 so as to contact the serrated edge 53 on the member 52 extending from the article carrier on the side of the process conveyor 14 on which the limit switches 86, 86a are located and to be periodically operated by such contact with the serrated edge 53 as the article carrier 17 is being transported by the process conveyor 14 past the radiation source 10. The system controller 18 measures the frequency of said operation of the limit switches 86, 86a and turns off all of the conveyors 12, 13, 14, 15 and the radiation source 10 wh en the measured frequency is outside a predetermined frequency range such that the speed at which the article carrier 17 is being transported is outside of a given speed range.

Once the condition that caused either the monitored speed of the process conveyor drive motor or the measured frequency of operation of either of the limit switch 86, 86a to be outside their respective predetermined ranges has been identified and alleviated, operation of all of the conveyors 12, 13, 14, 15 and operation of the radiation source 10 are resumed. Upon such resumption, the process conveyor controller 76 controls the acceleration and speed of transport by the process conveyor servo drive motor in relation to a given scanning energy level rise rate and a given width of the radiation beam in the direction of transport such that the portion of the article being scanned upon said interruption of radiation and transport is scanned with a total pre-and-post-interruption radiation dosage within a prescribed dosage range.

Once an article carrier 17 is positioned on the process conveyor 14 and being transported past the radiation source 10, contact by a following carrier 17 is not allowed because such contact would affect the uniform motion of the carrier 17 past the radiation source 10. The load conveyor controller 65 controls the acceleration and speed of the load conveyor 13 to prevent contact between the article carriers 17 as they are positioned on the process conveyor 14 such that there is a predetermined distance between adjacent positioned article carriers 17.

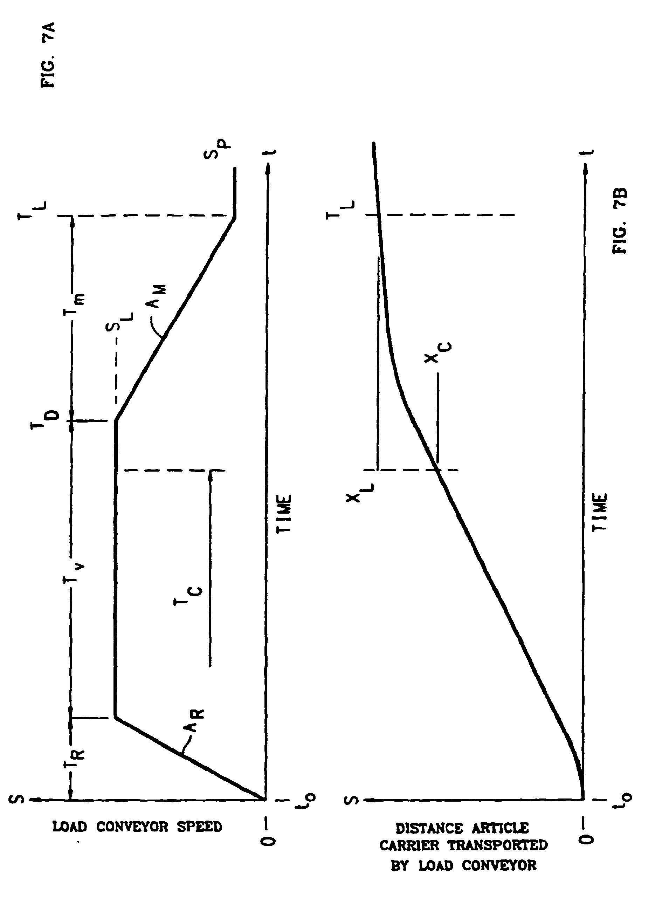

A characteristic curve of the speed of the load conveyor 13 as a function of time is shown in Figure 7A.

A characteristic curve of the distance over which each article carrier 17 is transported by the load conveyor 13 as a function of time is shown in Figure 7B, which has the same time scale as Figure 7A.

Referring to Figure 7A, the load conveyor 13 begins movement from the release point 58 at a time $t_o$, by being accelerated at an acceleration rate $A_R$ for a period of time $T_R$ to a speed $S_L$ that is greater than the speed $S_P$ of the process conveyor 14. The load conveyor 13 then transports the article carrier 17 at the speed $S_L$ for a variable period of time $T_V$ until a time $t_D$, when the load conveyor 13 begins to decelerate at a rate of deceleration $A_M$ for a variable period of time $T_M$ which ends at a total elapsed time $T_L$ from the time $t_o$ when the speed of the load conveyor 13 matches the speed Sp of the process conveyor 14 whereupon the leading edge of the article carrier 17 is placed on the upwardly inclined section 82 of the process conveyor 14.

Referring to Figure 7B, the distance $X_L$ over which each article carrier 17 is transported by the load conveyor 13 during the time period $T_L$ is a constant in accordance with the dimensions of the load conveyor 13.

Referring again to Figure 7A, although the speed Sp of the process conveyor 14 may be adjusted from time to time in accordance with the radiation dosage requirements for the particular articles being transported past the radiation source, in the preferred embodiment of the present invention, the total elapsed time $T_L$ over which the load conveyor 13 transports an article carrier 17 from the release point 58 to the process conveyor 14 is constant, notwithstanding the speed $S_P$ of the process conveyor 14. Also, in the preferred embodiment, the acceleration rate $A_R$, the acceleration time period $T_R$, the load conveyor speed $S_L$ during the period $T_V$ between acceleration and deceleration, and the deceleration rate $A_M$ all are constants for all process conveyor speeds $S_P$.

Therefore, in the preferred embodiment, the time $t_D$, at which the load conveyor 13 begins to decelerate is earlier when the speed $S_P$ of the process conveyor 14 is slower.

The total elapsed time $T_L$ from the time $t_o$ until the speed of the load conveyor 13 matches the speed $S_P$ of the process conveyor 14 is equal to the sum of the acceleration time period $T_R$, the variable time period $T_V$ and the variable deceleration time period $T_M$.

$$T_L = T_R + T_V + T_M; \qquad\qquad (Eq.1)$$

wherein

$$T_V = \frac{X_L - S_L^2 / 2A_R - (S_L^2 - S_P^2) / 2A_M}{S_L}; \quad (Eq.2)$$

and

$$T_M = \frac{S_L - S_P}{A_M}. \quad (Eq.3)$$

The time interval $T_I$ between the beginning of transport of successive article carriers 17 by the transport conveyor 13 is determined in accordance with the length $L_C$ of the article carrier 17, the predetermined separation distance $L_S$ between successive article carriers 17 while being transported by the process conveyor 14 past the radiation source 10, and the speed $S_P$ of the process conveyor 14.

$$T_I = \frac{L_C + L_S}{S_P} \quad (Eq.4)$$

To prevent interference between the carrier 17 that is released onto the load conveyor 13 and the following carrier 17, there must be a time delay $T_D$ before the following carrier 17 can be released.

The time interval $T_I$ must be greater than the sum of the carrier release time delay $T_D$ plus the time period $T_P$ for the next carrier 17 to advance to the release point 58 plus the time period $T_G$ for the transport conveyor dog 55 to travel a distance equal to the spacing distance $X_G$ between the dogs 55 on the chain 54.

$$T_I > T_D + T_P + T_G \qquad\qquad\qquad (Eq.5)$$

The time period $T_P$ is dependent upon the length $L_C$ of the article carrier 17 and the speed $S_T$ of movement of the transport conveyor dogs 55.

$$T_P = \frac{L_C}{S_T} \quad (Eq.6)$$

The time period $T_G$ is dependent upon the spacing distance $X_G$ between the transport conveyor dogs 55 and the speed $S_T$ of movement of the transport dogs 55.

$$T_G = \frac{X_G}{S_T} \quad (Eq.7)$$

In order to obtain the predetermined separation distance $L_S$ between successive article carriers 17 on the process conveyor 14, the time interval $T_I$ must also be greater than the total time $T_L$ over which the load conveyor 13 transports the article carrier 17 plus the time $T_G$ required for a transport conveyor dog 55 to travel the dog spacing distance $X_G$.

$$T_I > T_L + T_G \qquad\qquad\qquad (Eq.8)$$

The time $t_D$ at which deceleration by the load conveyor 13 begins is the sum of the acceleration time period $T_R$ plus the variable time period $T_V$ of constant load conveyor speed $S_L$.

$$t_D = T_R + T_V \qquad\qquad\qquad (Eq.9)$$

The minimum time

$$t_{D_{MIN}}$$

at which deceleration by the load conveyor 13 can begin must be greater than the time interval $T_C$ beginning at the release time $t_0$ required for an article carrier 17 to travel such a distance $X_C$ as to be sufficiently clear of the next released carrier 17 as to prevent contact between the successively transported carriers 17. The distance $X_C$ is determined by the geometrical dimensions of the articles carriers 17 and the path traveled by the article carriers 17 from the release point 58 around the 90-degree turn and then straight to the process conveyor 14.

$$t_{D_{MIN}} = T_R + T_{V_{MIN}} > T_C: \quad (Eq.10)$$

wherein

$$t_{D_{MIN}}$$

is dependent upon the minimum process conveyor speed

$$S_{P_{MIN}}.$$

$$T_{V_{MIN}} = \frac{X_L - S_L^2 / 2A_R - (S_L^2 - S_{P_{MIN}}^2)/2A_M}{S_L}; \quad (Eq.11)$$

and

$$T_C = \frac{X_C}{S_L} + \frac{S_L}{2A_R}. \quad (Eq.12)$$

In the preferred embodiment, the clearance distance $X_C$ is considerably larger than the length $L_C$ of the article carrier 17 because of the movement of the article carriers 17 around a 90-degree turn, as described above.

In alternative preferred embodiments, one or more of the total time $T_L$ over which the load conveyor 13 transports an article carrier 17 from the release point 58 to the process conveyor 14, the acceleration rate $A_R$, the acceleration time period $T_R$, the load conveyor speed $S_L$ during the period $T_V$ between acceleration and deceleration, and the deceleration rate $A_M$ may be adjusted for different process conveyor speeds $S_P$.

The load conveyor controller 65 is programmed to establish the acceleration $A_R$ and the deceleration $A_M$ as functions of time. By maintaining the acceleration rate $A_R$, the acceleration time period $T_R$, the load conveyor speed $S_L$ during the period $T_V$ between acceleration and deceleration, and the deceleration rate $A_M$ as constants for all process conveyor speeds $S_R$ programming of the load conveyor controller 65 is simplified.

The load conveyor controller 65 and the process conveyor controller 76 each have a finite encoder count capacity which requires that the count be initialized periodically to avoid overflowing the count register. For the load conveyor controller 65 and the the process conveyor controller 76, initialization occurs when an auxiliary chain dog 71 contacts and thereby operates a limit switch 87 during each carrier movement cycle. This method of periodic encoder count initialization maintains system accuracy by eliminating accumulated count errors which would produce positional drift and adversely affect system reliability.

During operation, the point in time when the load conveyor 13 begins to transport an article carrier from the release point 58 is determined by subtracting a calculated time value $T_Q$ from the overall time interval $T_I$. The time value $T_Q$ is determined by the geometrical dimensions of the load conveyor 13 and the process conveyor 14 and the location of the limit switch 87 that is operated by the auxiliary chain dog 71.

With the radiation source 10 being disposed along an approximately horizontal axis, the disposition of the process conveyor 14 in relation to the radiation source 10 is such that articles carried by article carriers 17 having a first horizontal orientation receive radiation impinging upon a first side of the articles.

The reroute conveyor 15 branches from the transport conveyor 12 at a track switch 88 located beyond the process conveyor 14 and transports those article carriers 17 carrying articles that have received radiation impinging upon only the first side of the articles.

Operation of the track switch 88 occurs in response to operation of one or the other of a pair of limit switches 89, 90, which are mounted in stationary positions on opposite sides of the transport conveyor track 20 between the process conveyor 14 and the track switch 88 for detecting whether or not an article carrier 17 transported from the process conveyor 14 has been reoriented. One or the other of the limit switches 88, 89 is operated by contact with the striker tab 49 extending vertically from one side of the outer collar 47 of the carrier 17 after the carrier 17 has been transported past the radiation source 10 by the process conveyor 14.

When the article carrier 17 that has just been transported past the radiation source 10 is oriented such that the radiation impinged on the first side of the articles in the article carrier 17, the striker tab 49 is on the same side of the transport conveyor 12 as the limit switch 90, whereupon the striker tab 49 contacts the limit switch 90 as the carrier is being transported past the limit switch 90 to operate the limit switch 90 to cause the track switch 88 to be so operated as to route the article carrier 17 onto the reroute conveyor 15.

The reroute conveyor 15 also is an overhead power and free conveyor, which includes a track extending from the track switch 88 to a passive merge junction 91, from which track the article carriers 17 are suspended during transport, and a chain with dogs attached thereto disposed to one side of the reroute conveyor track so that such dogs can engage the bar 51 attached to the trolley 45 of an article carrier 17 to thereby push the article carrier 17 along the path of the reroute conveyor track. The reroute conveyor chain (not shown) is coupled by gears (not shown) to the transport conveyor chain 54 and is thereby driven at the same speed at the transport conveyor chain 54.

Article carriers 17 transported by the reroute conveyor 15 are reoriented about a vertical axis by 180 degrees and transferred back onto the transport conveyor 12 at the passive merge junction 91 prior to the staging area 59 for retransportation by the transport conveyor 12 and the load conveyor 13 to the process conveyor 14 and for retransportation past the radiation source 10 by the process conveyor 14 so that a second side of the carried articles opposite to the first side receives impinging radiation from the radiation source 10.

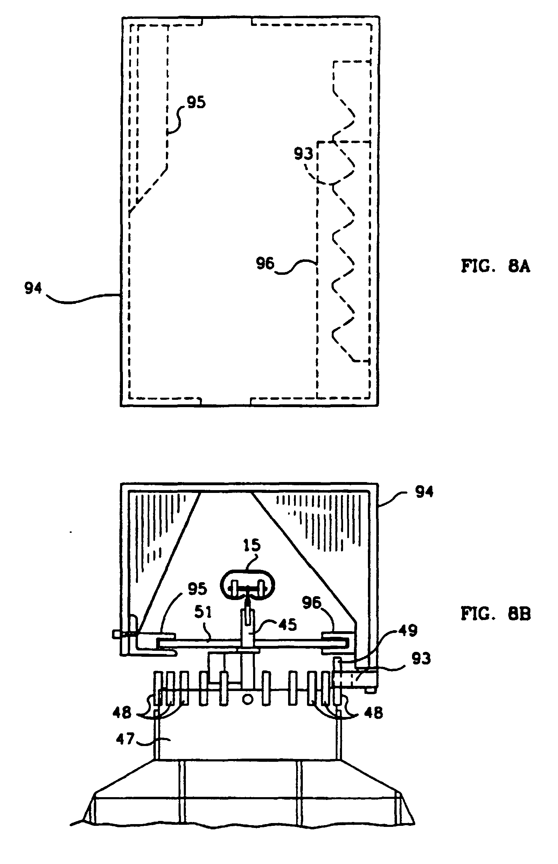

The article carrier 17 is constructed to rotate so that it can be reoriented about a vertical axis by sequential engagement with a gear rack 93 disposed adjacent the reroute conveyor 15. Referring to Figures 8A and 8B, the gear rack 93 is supported by a framework 94.

As indicated above, the trolley 45 rides on the transport conveyor track 20 and is coupled to the article carrier top cross member 38 in such a manner as to rotatably suspend the article carrier 17 from the conveyor track 20. The inner collar 46 is non-rotatably attached to the trolley 45; and the outer collar 47 is non-rotatably attached to the top cross member 38 at the top of the article carrier 17. The outer collar 47 is rotatable in relation to the inner collar 46 and thereby is rotatable in relation to the trolley 45 so that the article carrier 17 is rotatable in relation to the reroute conveyor 15.

The series of pins 48 attached to the outer collar 47 are vertically oriented when the article carrier 17 is suspended from the reroute conveyor 15 and are thereby disposed to sequentially engage the teeth of the gear rack 93, which is mounted in a stationary position in relation to the track of the reroute conveyor track 15, such that as the article carrier 17 is being transported by the reroute conveyor 15, the pins 48 are sequentially engaged by the gear rack 93 to rotate the article carrier 17. The interaction between the pins 48 and the gear rack 93 rotates the article carrier by 180 degrees.

A guide mechanism including bearings and detents couple the inner collar 46 to the outer collar 47 in order to maintain the rotational orientation of the article carrier 17 when the carrier 17 is not being rotated by the engagement of the pins 48 with the gear rack 93.

Also supported within the framework 94 are a first slotted member 95 laterally disposed on the opposite side of the framework 94 from the gear rack 93 adjacent the entrance end of the framework 94 and a second slotted member 96 laterally disposed on the same side of the framework 94 as the gear rack 93, adjacent the exit end of the framework 94, but below the the gear rack 93. These two slotted members 95, 96 are disposed at the height of the bar 51 of an article carrier 17 supported from the reroute conveyor track 15 within the framework 94 so as to provide restraint against lateral movement of the article carrier 17 as the article carrier 17 is being rotated by the interaction between the pins 48 and the gear rack 93 as the article carrier is being transported along the reroute conveyor track 15.

A limit switch 92 is mounted in a stationary position between the gear rack 93 and the track switch 88 for detecting the presence of an article carrier 17 on the reroute track 15. The limit switch 92 is disposed in relation to the reroute conveyor track 15 so that it is operated by contact with the striker tab 49 extending vertically from one side the outer collar 47 of the article carrier 17.

Another limit switch 97 is mounted in a stationary position in relation to the reroute conveyor 15 between the gear rack 93 and the merge junction 91 for detecting whether or not an article carrier 17 transported onto the reroute conveyor 15 from the process conveyor 14 has been reoriented 180 degrees by the gear rack 93. If the carrier 17 has been rotated 90 degrees about a vertical axis by the gear rack 93, the limit switch 97 is operated by contact with the striker tab 49 extending vertically from one side the outer collar 47 of the carrier 17.

The limit switches 92 and 97 are connected to the system controller 18; and when the correct orientation of an article carrier 17 is not detected by operation of the limit switch 97 within a predetermined time window following operation of the limit switch 92, the system controller 18 responds by interrupting both radiation from the radiation source 10 and transport of all of the article carriers 17 by all of the conveyors 12, 13, 14, 15 of the conveyor system. After the article carrier 17 has been correctly oriented, operation of all of the conveyors 12, 13, 14, 15 and operation of the radiation source 10 are resumed, as described above.

When the article carrier 17 that has just been transported past the radiation source 10 is oriented such that the radiation impinged on the second side of the articles in the article carrier 17, the striker tab 49 is on the same side of the transport conveyor 12 as the limit switch 89, whereupon the striker tab 49 contacts the limit switch 89 as the carrier is being transported past the limit switch 89 to operate the limit switch 89 to cause the track switch 88 to be so operated as to route the article carrier 17 onto an extended portion 99 of the transport conveyor 12 for transportation to an unloading area 98.

Another limit switch 100 is mounted in a stationary position on the same side of the transport conveyor track 20 as the limit switch 89 and adjacent the extended portion 99 of the transport conveyor 12 for detecting when the article carrier 17 that has just been transported past the radiation source 10 is oriented such that the radiation impinged on the second side of the articles in the article carrier 17, which indicates proper operation of the track switch 88. The limit switch 100 is operated by contact with the striker tab 49 that extends vertically from the one side of the outer collar 47 of the carrier 17 when the carrier 17 that has just been transported past the radiation source 10 by the process conveyor 14 is correctly routed by the track switch 88.

If the limit switch 100 is not operated within a predetermined time window following operation of the limit switch 89, a malfunction of the track switch 88 is detected.

The limit switch 100 is connected to the system controller 18: and if the limit switch 100 is not operated within a predetermined time window following operation of the limit switch 89, a malfunction of the track switch 88 is detected by the system controller 18. When a malfunction of the track switch 88 is so detected, the system controller 18 responds by Interrupting both radiation from the radiation source 10 and transport of all of the article carriers 17 by all of the conveyors 12, 13, 14, 15 of the conveyor system. After the article carrier 17 has been correctly oriented, operation of all of the conveyors 12, 13, 14, 15 and operation of the radiation source 10 are resumed

In the loading area 34, a mask 102 is mounted in a stationary position in relation to the transport conveyor 12 for biocking passage of an article carrier 17 that does not have the striker tab 49 on the side of the article carrier 17 that will receive impinging radiation from the radiation source 10 when the article carrier 17 is first transported past the radiation source 10. The mask 102 has an opening that permits passage of the article carrier 17 only when the striker tab 49 is on such side of the article carrier 17.

Within the entry 31 to the process chamber 30 and the passageway 32, the portion of the transport conveyor 12 that transports the article carriers 17 from the loading area 34 to the process chamber 30 is elevated with respect to the extended portion 99 of the transport conveyor 12 that transports the article carriers from the process conveyor 14 to the unloading area 98.

Refening to Figure 9, the transport conveyor chain within the slotted tube 21 is driven by a sprocket wheel 104 coupled to the drive motor 56 and passes around an idler sprocket wheel 106 coupled to a chain tensioning device 107. The track tube 20 takes a separate route from the slotted tube 21 within the unloading area 98 and the loading area 34 so that the article carriers can be manually stopped and unloaded. The article carriers 17 are then pushed manually along the route of the track 20 to the loading area 34 where they are loaded with a new set of articles to be irradiated. Beyond the loading area 34 the tracks 20 and 21 merge to be adjacent each other so as to enable the transport conveyor 12 to transport the article carriers 17 into the process chamber 30.

## Claims

**1.** Irradiation system apparatus for sterilizing articles, comprising a radiation source a plurality of article carriers (17); a process conveyor (14) for transporting the article carriers past the radiation source (10) at a first speed; a transport conveyor (12) for transporting the article carriers from a loading area (34) at a second speed that differs from said first speed; and a load conveyor (13) adapted for engaging the article carriers and for transporting the engaged article carriers from the transport conveyor to position the article carriers on the process conveyor in such a manner that when the article carriers are positioned on the process conveyor there is a predetermined separation distance between adjacent positioned article carriers;

**characterised in that** a controller (65, 18) varies the speed of the load conveyer during said transport by the load conveyor the controller (18) being adapted in accordance with the speed of the process conveyor (14) for causing the load conveyor (13) to be transporting the article carrier (17) at the same speed as the process conveyor when the load conveyor positions the article carrier on the process conveyor and wherein the transport conveyor (12) is an overhead power-and-free conveyor that maintains contact with the article carriers (17) as the article carriers are being transported past the radiation source (10) by the process conveyor (14) at a speed independent of the speed of the transport conveyor, and transports the article carriers away from the process conveyor after the article carriers are transported past the radiation source, and the process conveyor (14) includes a level section (81) which supports the article carriers (17) while the article carriers are being transported past the radiation source (10) and an upwardly inclined section (82) onto which the article carriers transported by the load conveyor (13) are positioned on the process conveyor (14) so that the article carriers are elevated as they are positioned on the process conveyor so that the article carriers are not supported by the overhead transport conveyor (12) while being transported by the process conveyor past the radiation source.

2. Apparatus according to Claim 1, **characterised in that** during said transport by the load conveyor (13), said controller (18) increases said speed of transport by the load conveyor to a speed above the first speed and subsequently gradually reduces to be at the first speed when the article carrier (17) is positioned on the process conveyor (14).

3. Apparatus according to any preceding claim, wherein the article carriers (17) have a maximum length and the transport conveyor (12) is an overhead power-and-free conveyor having a movable chain (54) and dogs (55) that are attached to the chain at intervals greater than the maximum article carrier length for engaging the article carriers to transport the article carriers, wherein a said dog is disengaged from a said article carrier when the said article carrier is restrained from movement by at least a predetermined restraining force, **characterised by**

an escapement (57) located next to the transport conveyor for restraining said article carriers with at least said predetermined restraining force at a release point from which a said article carrier is transported from the transport conveyor by the load conveyor (13); and
a controller (18) coupled to the load conveyor and adapted in accordance with the speed of the process conveyor (14) for causing the load conveyor to engage the said restrained article carrier for transport by the load conveyor and to override the restraint applied by the escapement at a release time that results in the said article carrier being positioned on the process conveyor at the predetermined separation distance from another said article carrier next previously positioned on the process conveyor after the load conveyor transports the said article carrier from the transport conveyor to the process conveyor at said varied speed.

4. Apparatus according to Claim 1, wherein each carrier (17) includes end members (39) as defined by the direction in which the article carriers are transported by the process conveyor (14),
**characterised by** the end members having supporting struts (40) disposed on the outside of said end members, with the struts being disposed differently on one end member than on the other end member so that the struts on one said article carrier cannot contact the struts on another said article carrier positioned adjacent thereto on the process conveyor with the same lateral orientation as the one said article carrier notwithstanding the end-to-end orientation of the article carriers, whereby the article carriers can be positioned closer together than would be possible if the struts on one said article carrier could contact the struts on another sold article carrier when said article carriers are positioned adjacent each other on the process conveyor with said same lateral orientation.

5. Apparatus according to Claim 1, wherein the radiation source (10) is disposed along an approximately horizontal axis and the process conveyor (14) is disposed in relation to the radiation source such that articles carried by article carriers having a first horizontal orientation receive radiation impinging upon a first side of the articles; and a reroute conveyor (15) is coupled to the process conveyor for reorienting the article carriers for retransportation past the radiation source by the process conveyor so that a second side of the said carried articles opposite to said first side receives impinging radiation from the radiation source,
**characterised by** means (89, 90) for detecting whether or not a said article carrier (17) transported from the process conveyor (14) has been reoriented; and
means (88) coupled to the detecting means for routing said article carrier to the reroute conveyor (15) when the detecting means detect that said article carrier has not been reoriented and for routing said article carrier for transportation to an unloading area (98) when the detecting means detect that said article carrier has been rerouted.

6. Apparatus according to Claim 1, wherein the radiation source (10) is disposed along an approximately horizontal axis and the process conveyor (14) Is disposed in relation to the radiation source such that articles carried by article carriers having a first horizontal orientation receive radiation impinging upon a first side of the articles; and a reroute conveyor (15) is coupled to the process conveyor for reorienting the article carriers for retransportation past the radiation source by the process conveyor so that a second side of the said carried articles opposite to said first side receives impinging radiation from the radiation source,
**characterised by** means (97) for detecting misorientation or a said article carrier (17); and
means (18) responsive to said detection of misorientation of said article carrier for interrupting both radiation from said radiation source and said transport by the process conveyor.

7. Apparatus according to Claim 1, wherein the radiation source is adapted for scanning articles carried by the article carriers (17) being transported by the process conveyor (14) with a radiation beam that scans the transported articles at a given rate in a plane perpendicular to the direction of transport, **characterised by**

means (18) adapted for measuring a speed at which said article carrier is being transported past the radiation source;

means (18) adapted for processing said measurements to determine whether said article carrier transport speed is outside of a given range; and

means (18) responsive to said processing means for interrupting both radiation from said radiation source and said transport by the process conveyor when the processing means determine that the article carrier transport speed is outside of said given range.

8. Apparatus according to Claim 7, **characterised in that** the measuring means include a member (52) attached to each article carrier having a serrated edge (53) extending away from the article carrier (17); and a limit switch (86, 86a) disposed in relation to the process conveyor (14) so as to be periodically operated by contact with the serrated edge of said member as a said article carrier is being transported by the process conveyor past the radiation source (10).

9. Apparatus according to Claim 8, **characterised in that** the processing means (18) are adapted for measuring the frequency of said operation of the limit switch (86, 86a); and the responsive means (18) are adapted for inter-rupting said radiation and said transport when said measured frequency is outside a predetermined frequency range.

10. Apparatus according to Claim 7, wherein the radiation beam has a given width in the direction of transport, **characterised by**

means (18) for resuming said transport by the conveyor and said radiation from said radiation source (10); and means (76) for controlling the acceleration and speed of transport by the conveyor upon said resumption in relation to a given scanning energy level rise rate and the given width of said radiation beam such that the portion of the article being scanned upon said interruption of radiation and transport is scanned with a total pre-and-post interruption radiation dosage with a prescribed dosage range.

**Patentansprüche**

1. Bestrahlungssystemvorrichtung zum Sterilisieren von Gegenständen

- mit einer Strahlungsquelle,
- mit einer Vielzahl von Gegenstandsträgern (17),
- mit einem Behandlungsförderer (14) zum Transportieren der Gegenstandsträger vorbei an der Strahlungsquelle (10) mit einer ersten Geschwindigkeit,
- mit einem Transportförderer (12) zum Transportieren der Gegenstandsträger von einem Beladebereich (34) aus mit einer zweiten Geschwindigkeit, die sich von der ersten Geschwindigkeit unterscheidet, und
- mit einem Ladeförderer (13), der dafür ausgelegt ist, die Gegenstandsträger zu greifen und die in Eingriff gebrachten Gegenstandsträger von dem Transportförderer aus zu transportieren, um die Gegenstandsträger auf dem Behandlungsförderer so zu positionieren, dass, wenn die Gegenstandsträger auf dem Behandlungsförderer positioniert sind, zwischen benachbarten positionierten Gegenstandsträgern ein vorgegebener Trennabstand vorhanden ist,

**dadurch gekennzeichnet,**

- **dass** eine Steuereinrichtung (65, 18) die Geschwindigkeit des Ladeförderers während des Transports durch den Ladeförderer ändert,
- **dass** die Steuereinrichtung (18) entsprechend der Geschwindigkeit des Behandlungsförderers (14) so ausgelegt ist, dass sie den Ladeförderer (13) veranlasst, den Gegenstandsträger (17) mit der gleichen Geschwindigkeit wie der Behandlungsförderer zu transportieren, wenn der Ladeförderer den Gegenstandsträger auf dem Behandlungsförderer positioniert, und
- wobei der Transportförderer (12) ein Überkopf-Schleppkreisförderer ist, der Kontakt zu den Gegenstandsträgern (17) hält, wenn die Gegenstandsträger durch den Behandlungsförderer (14) an der Strahlungsquelle (10) vorbei mit einer Geschwindigkeit transportiert werden, die von der Geschwindigkeit des Transportförderers unabhängig ist, und der die Gegenstandsträger nach dem Transport der Gegenstandsträger vorbei an der Strahlungsquelle von dem Behandlungsförderer weg transportiert, und
- wobei der Behandlungsförderer (14) einen Niveauabschnitt (81), der die Gegenstandsträger (17) abstützt, während die Gegenstandsträger an der Strahlungsquelle (10) vorbei transportiert werden, und einen nach oben geneigten Abschnitt (82) aufweist, auf dem die von dem Ladeförderer (13) transportierten Gegenstandsträger auf dem Behandlungsförderer (14) so positioniert werden, dass die Gegenstandsträger angehoben sind, wenn sie auf dem Behandlungsförderer positioniert sind, so dass die Gegenstandsträger nicht von dem Überkopftransportförderer (12) getragen werden, während sie von dem Behandlungsförderer an der Strahlungsquelle vorbei transportiert werden.

2. Vorrichtung nach Anspruch 1, **dadurch gekennzeichnet, dass** während des Transports durch den Ladeförderer (13) die Steuereinrichtung (18) die Geschwindigkeit für den Transport durch den Ladeförderer auf eine Geschwindigkeit über der ersten Geschwindigkeit erhöht und anschließend allmählich verringert, so dass sie der ersten Geschwindigkeit entspricht, wenn der Gegenstandsträger (17) auf dem Behandlungsförderer (14) positioniert ist.

3. Vorrichtung nach einem vorhergehenden Anspruch, bei welcher die Gegenstandsträger (17) eine maximale Länge aufweisen und der Transportförderer (12) ein Überkopf-Schleppkreisförderer ist, der eine bewegliche Kette (54) und Mitnehmer (55) aufweist, die an der Kette in Abständen befestigt sind, die größer sind als die maximale Länge des Gegenstandsträgers, um die Gegenstandsträger für ihren Transport zu greifen, wobei der Eingriff des Mitnehmers an dem Gegenstandsträger gelöst wird, wenn der Gegenstandsträger durch wenigstens eine vorgegebene Rückhaltekraft von einer Bewegung abgehalten wird,
**gekennzeichnet**

- **durch** eine Hemmeinrichtung (57), die in der Nähe des Transportförderers zum Zurückhalten der Gegenstandsträger mit wenigstens der vorgegebenen Rückhaltekraft an einem Freigabepunkt angeordnet ist, von dem aus ein Gegenstandsträger von dem Transportförderer aus durch den Ladeförderer (13) transportiert wird, und
- **durch** eine Steuereinrichtung (18), die mit dem Ladeförderer gekoppelt ist und entsprechend der Geschwindigkeit des Behandlungsförderers (14) so ausgelegt ist, dass der Ladeförderer dazu gebracht wird, an dem zurückgehaltenen Gegenstandsträger für einen Transport durch den Ladeförderer anzugreifen und die von der Hemmeinrichtung ausgeübte Rückhaltung zu einer Freigabezeit zu überwinden, was dazu führt, dass der Gegenstandsträger auf dem Behandlungsförderer in dem vorgegebenen Trennabstand von einem weiteren Gegenstandsträger positioniert wird, der vorher als nächster auf dem Behandlungsförderer nach dem Transport des Gegenstandsträgers durch den Ladeförderer mit der variierten Geschwindigkeit von dem Transportförderer zu dem Behandlungsförderer positioniert worden ist.

4. Vorrichtung nach Anspruch 1, bei welcher jeder Träger (17) Stirnelemente (39) aufweist, die durch die Richtung, in der die Gegenstandsträger durch den Behandlungsförderer (14) transportiert werden, definiert sind,
**dadurch gekennzeichnet, dass** die Stirnelemente Haltestreben (40) aufweisen, die an der Außenseite der Stirnelemente angeordnet sind, wobei die Streben an einem Stirnelement anders als am anderen Stirnelement angeordnet sind, so dass die Streben an einem Gegenstandsträger die Streben am anderen Gegenstandsträger, der angrenzend daran auf dem Behandlungsförderer mit der gleichen seitlichen Ausrichtung wie der eine Gegenstandsträger positioniert ist, trotz der Ausrichtung Stirnseite gegen Stirnseite der Gegenstandsträger nicht berühren können, wodurch die Gegenstandsträger enger zusammen angeordnet werden können als es möglich wäre, wenn die Streben an dem einen Gegenstandsträger die Streben an dem anderen Gegenstandsträger berühren könnten, wenn die Gegenstandsträger angrenzend aneinander auf dem Behandlungsförderer mit der gleichen seitlichen Ausrichtung angeordnet sind.

5. Vorrichtung nach Anspruch 1, bei welcher die Strahlungsquelle (10) längs einer annähernd horizontalen Achse angeordnet ist und der Behandlungsförderer (14) in einer solchen Beziehung zur Strahlungsquelle angeordnet ist, dass von den eine erste horizontale Ausrichtung aufweisenden Gegenstandsträgern getragene Gegenstände auf eine erste Seite der Gegenstände auftreffende Strahlung empfangen, und ein Umleitförderer (15) mit dem Behandlungsförderer für eine Neuausrichtung der Gegenstandsträger für einen erneuten Transport durch den Behandlungsförderer vorbei an der Strahlungsquelle gekoppelt ist, so dass eine zweite Seite der getragenen Gegenstände, die der ersten Seite gegenüberliegt, die auftreffende Strahlung von der Strahlungsquelle empfängt, **gekennzeichnet**

- **durch** Einrichtungen (89, 90) zum Erfassen, ob ein von dem Behandlungsförderer (14) transportierter Gegenstandsträger (17) neu ausgerichtet worden ist oder nicht, und
- **durch** Einrichtungen (88), die mit der Erfassungseinrichtung zum Leiten des Gegenstandsträgers zu dem Umleitförderer (15) verbunden sind, wenn die Erfassungseinrichtung feststellt, dass der Gegenstandsträger nicht neu ausgerichtet worden ist, und zum Leiten des Gegenstandsträgers für einen Transport zu einem Entladebereich (98), wenn die Erfassungseinrichtung feststellt, dass der Gegenstandsträger umgeleitet worden ist.

6. Vorrichtung nach Anspruch 1, bei welcher die Strahlungsquelle (10) längs einer annähernd horizontalen Achse angeordnet ist und der Behandlungsförderer (14) in einer solchen Beziehung zu der Strahlungsquelle angeordnet ist, dass von den eine erste horizontale Ausrichtung aufweisenden Gegenstandsträgern getragene Gegenstände auf eine erste Seite der Gegenstände auftreffende Strahlung empfangen, und ein Umleitförderer (15) mit dem Behandlungsförderer für eine Neuausrichtung der Gegenstandsträger für einen erneuten Transport durch den Behandlungsförderer vorbei an der Strahlungsquelle gekoppelt ist, so dass eine zweite Seite der getragenen Gegenstände, die der ersten Seite gegenüberliegt, auftreffende Strahlung von der Strahlungsquelle empfängt, **gekennzeichnet**

   - **durch** Einrichtungen (97) zum Erfassen einer Fehlausrichtung eines Gegenstandsträgers (17) und
   - **durch** Einrichtungen (18), die auf das Erfassen der Fehlausrichtung des Gegenstandsträgers ansprechen und sowohl die Bestrahlung aus der Strahlungsquelle als auch den Transport durch den Behandlungsförderer unterbrechen.

7. Vorrichtung nach Anspruch 1, bei welcher die Strahlungsquelle für ein Bestreichen von Gegenständen, die von den von dem Behandlungsförderer (14) transportierten Gegenstandsträgern (17) getragen werden, mit einem Bestrahlungsstrahl ausgelegt ist, der die transportierten Gegenstände mit einer vorgegebenen Rate in einer Ebene senkrecht zur Transportrichtung bestreicht, **gekennzeichnet**

   - **durch** Einrichtungen (18), die für ein Messen einer Geschwindigkeit geeignet sind, mit welcher der Gegenstandsträger an der Strahlungsquelle vorbei transportiert wird,
   - **durch** Einrichtungen (18), die für das Verarbeiten der Messungen geeignet sind, um zu bestimmen, ob die Gegenstandsträgertransportgeschwindigkeit außerhalb eines vorgegebenen Bereichs liegt und
   - **durch** Einrichtungen (18), die auf die Verarbeitungseinrichtung zum Unterbrechen sowohl der Strahlung von der Strahlungsquelle als auch des Transports durch den Behandlungsförderer ansprechen, wenn die Verarbeitungsvorrichtung bestimmt, dass die Gegenstandsträgertransportgeschwindigkeit außerhalb des vorgegebenen Bereichs liegt.

8. Vorrichtung nach Anspruch 7, **dadurch gekennzeichnet, dass** die Messeinrichtungen ein an jedem Gegenstandsträger befestigtes Element (52) mit einem gezackten Rand (53), der sich vom Gegenstandsträger (17) weg erstreckt, und einen Begrenzungsschalter (86, 86a) aufweist, der in Beziehung zu dem Behandlungsförderer (14) so angeordnet ist, dass er durch den Kontakt mit dem gezackten Rand des Elements periodisch betätigt wird, wenn der Gegenstandsträger durch den Behandlungsförderer an der Strahlungsquelle (10) vorbei transportiert wird.

9. Vorrichtung nach Anspruch 8, **dadurch gekennzeichnet, dass** die Verarbeitungseinrichtungen (18) geeignet sind, die Häufigkeit der Betätigung des Begrenzungsschalters (86, 86a) zu messen und dass die Ansprecheinrichtungen (18) geeignet sind, die Strahlung und den Transport zu unterbrechen, wenn die gemessene Häufigkeit außerhalb eines vorgegebenen Häufigkeitsbereichs liegt.

10. Vorrichtung nach Anspruch 7, bei welcher der Bestrahlungsstrahl eine vorgegebene Breite in der Transportrichtung hat, **gekennzeichnet**

   - **durch** Einrichtungen (18) für die Wiederaufnahme des Transports durch den Förderer und der Bestrahlung aus der Strahlungsquelle (10) und
   - **durch** Einrichtungen (76) zum Steuern der Beschleunigung und der Transportgeschwindigkeit durch den Förderer nach der Wiederaufnahme in Beziehung zu einer vorgegebenen Bestreichungsenergiepegel-Anstiegsrate und der vorgegebenen Breite des Bestrahlungsstrahls derart, dass der Abschnitt des Gegenstandes, der nach Unterbrechung der Bestrahlung und des Transports bestrichen wird, mit einer Gesamt-Vor-und-Nach-Unterbrechung-Strahlungsdosis in einem vorgegebenen Dosierungsbereich bestrichen wird.

**Revendications**

1. Appareil pour système d'irradiation ou de rayonnement électromagnétique pour stériliser des articles, comprenant une pluralité de supports
d'articles (17) ; un convoyeur de traitement ou production (14) pour acheminer les supports d'articles devant une source d'irradiation ou de rayonnement électromagnétique (10) à une première vitesse ; un convoyeur d'acheminement (12) pour acheminer les supports d'articles depuis une zone de chargement (34) à une seconde vitesse qui diffère de ladite première vitesse : et un convoyeur de chargement (13) apte à introduire les supports d'articles et à acheminer les supports d'articles introduits à partir du convoyeur d'acheminement pour positionner les supports d'articles sur le convoyeur de traitement ou de production de telle sorte que lorsque les supports d'articles sont positionnés sur le convoyeur de traitement ou de production, on obtient une distance de séparation prédéterminée entre des supports d'articles qui sont positionnés de façon contiguë ;

**caractérisé en ce qu'**un organe de commande ou de régulation (65, 18) fait varier la vitesse du convoyeur de chargement pendant ledit acheminement par le convoyeur de chargement, et dans lequel l' organe de commande ou de régulation (18) est apte, en fonction de la vitesse du convoyeur de traitement ou de production (14), à faire en sorte que le convoyeur de chargement (13) achemine le support d'articles (17) à la même vitesse que le convoyeur de traitement lorsque le convoyeur de chargement positionne le support d'articles sur le convoyeur de traitement ou de production.

2. Appareil pour système selon la revendication 1, **caractérisé en ce que** pendant ledit acheminement par le convoyeur de chargement (13), ledit organe de commande ou de régulation (18) fait augmenter ladite vitesse d'acheminement par le convoyeur de chargement à une vitesse au-dessus de la première vitesse et la fait ensuite réduire progressivement pour qu'elle se situe à la première vitesse lorsque le support d'articles (17) est positionné sur le convoyeur de traitement ou de production (14).

3. Appareil pour système selon l'une quelconque des revendications précédentes, dans lequel les supports d'articles (17) ont une longueur maximum et le convoyeur d'acheminement (12) est un convoyeur aérien de type « Power and Free » comportant une chaîne mobile (54) et des taquets d'entraînement ou poussoirs (55) qui sont fixés sur la chaîne à des intervalles supérieurs à la longueur du support d'articles maximum pour l'engagement ou engrènement avec les supports d'articles et l'acheminement de ceux-ci, système dans lequel un taquet d'entraînement ou poussoir à came est désolidarisé d'un support d'articles lorsque le support d'articles est retenu par au moins une force de retenue prédéterminée, **caractérisé par**

un dispositif d'échappement (57) situé à proximité du convoyeur d'acheminement destiné à retenir lesdits supportsd'articles avec au moins ladite force de retenue prédéterminée en un point de libération à partir duquel un support d'articles est acheminé depuis le convoyeur d'acheminement par le convoyeur de chargement (13) ; et

un organe de commande ou de régulation (18) accouplé au convoyeur de chargement et apte, en fonction de la vitesse du convoyeur de traitement ou de production (14), à provoquer l'engagement ou engrènement dudit support d'articles retenu par le convoyeur de charges pour l'acheminement par ce dernier et pour supprimer la force de retenue appliquée par le dispositif d'échappement à un temps de libération, ce qui a pour effet que le support d'articles se positionne sur le convoyeur de traitement à la distance de séparation prédéterminée par rapport au support d'articles suivant préalablement positionné sur le convoyeur de traitement après que le convoyeur de chargement a acheminé ledit support d'articles depuis le convoyeur d'acheminement vers le convoyeur de traitement à ladite vitesse régulée ; et

le convoyeur d'acheminement (12) étant un convoyeur aérien de type « Power and Free » qui maintient le contact avec les supports d'articles (17) à mesure que les supports d'articles sont acheminés devant la source d'irradiation ou de rayonnement électromagnétique (10) par le convoyeur de traitement ou de production (14) à une vitesse indépendante de la vitesse du convoyeur d'acheminement et éloigne les supports d'articles du convoyeur de traitement après que les supports d'articles ont été acheminés devant la source d'irradiation ou de rayonnement électromagnétique ; et.

le convoyeur de traitement ou de production (14) comprend une section de niveau (81) sur laquelle repose les supports d'articles (17) tandis les supports d'articles sont acheminés devant la source d'irradiation ou de rayonnement électromagnétique (10) et une section inclinée vers le haut (82) sur laquelle sont positionnés les supports d'articles acheminés par le convoyeur de chargement (13) sur le convoyeur de traitement ou de production (14) de sorte que les supports d'articles sont élevés à mesure qu'ils sont positionnés sur le convoyeur de traitement ce qui a pour effet que les supports d'articles ne reposent plus sur le convoyeur d'acheminement aérien (12) tout en étant acheminés par le convoyeur de traitement devant la source d'irradiation ou de traitement électromagnétique.

4. Appareil pour système selon la revendication 1, dans lequel chaque support d'articles (17) comprend des éléments d'extrémité (39) comme cela est défini par la direction dans laquelle les supports d'articles sont acheminés par le convoyeur de traitement ou de production (14),

**caractérisé en ce que** les éléments d'extrémité comportent des entretoises de support ou étrésillons (40) disposés à l'extérieur des éléments d'extrémité, les étrésillons étant disposés d'une manière différente sur un élément d'extrémité par rapport à l'autre élément d'extrémité de sorte que les étrésillons sur un support d'articles ne peuventvenir en contact avec les étrésillons sur un autre support d'articles positionné de façon contiguë par rapport à celui-ci sur le convoyeur de traitement ayant la même orientation latérale que le support d'articles malgré l'orientation bout à bout des supports d'articles, les supports d'articles pouvant ainsi être positionnés de façon plus rapprochée que cela ne serait possible si les étrésillons sur un support d'articles pouvaient venir en contact avec les entretoises sur un autre support d'articles lorsque lesdits supports d'articles sont positionnés de façon contiguë l'un par rapport à l'autre sur le convoyeur de traitement avec ladite même orientation latérale.

5. Appareil pour système selon la revendication 1, dans lequel la source d'irradiation ou de rayonnement électromagnétique (10) est disposée le long d'un axe approximativement horizontal et le convoyeur de traitement ou de production (14) est disposé par rapport à la source d'irradiation de sorte que les articles transportés par les supports d'articles ayant une première orientation horizontale reçoivent l'irradiation venant en incidence sur un premier côté des articles ; et un convoyeur de réacheminement (15) est accouplé au convoyeur de traitement pour réorienter les supports d'articles en vue du réacheminement devant la source d'irradiation par le convoyeur de traitement de sorte qu'un second côté desdits articles transportés an opposition au premier côté, reçoit en incidence l'irradiation provenant de la source d'irradiation ou de rayonnement électromagnétique, **caractérisé par** des moyens (89, 90) destinés à détecter si un support d'articles (17) acheminé depuis le convoyeur de traitement ou de production (14) a été réorienté ; et des moyens (88) accouplés aux moyens de détection pour acheminer le support d'articles vers le convoyeur de réacheminement (15) lorsque les moyens de détection déterminent que ledit support d'articles n'a pas été réorienté et pour acheminer ledit support d'articles pour le transport vers une zone de déchargement (98) lorsque les moyens de détection détectent que ledit support d'articles a été réacheminé.

6. Appareil pour système selon la revendication 1, dans lequel la source d'irradiation ou de rayonnement électromagnétique (10) est disposée le long d'un axe approximativement horizontal et le convoyeur de traitement ou de production (14) est disposé par rapport à la source d'irradiation de sorte que les articles acheminés par les supports d'articles ayant une première orientation horizontale reçoivent l'irradiation venant en incidence sur un premier côté des articles ; et un convoyeur de réacheminement (15) est accouplé au convoyeur de traitement pour réorienter les supports d'articles en vue du réacheminement devant la source d'irradiation par le convoyeur de traitement de sorte qu'un second côté desdits articles transportés en opposition au premier côté reçoit l'irradiation venant an incidence depuis la source d'irradiation ou de rayonnement électromagnétique, **caractérisé par** des moyens (97) destinés à détecter une erreur d'orientation d'un support d'articles (17) ; et des moyens (18) sensibles à ladite détection d'une erreur d'orientation dudit support d'articles pour interrompre à la fois l'irradiation en provenance de ladite source d'irradiation ou de rayonnement électromagnétique et ledit acheminement par le convoyeur de traitement.

7. Appareil pour système selon la revendication 1, dans lequel la source d'irradiation est apte à explorer ou lire les articles transportés par les supports d'articles (17) acheminés par le convoyeur de traitement ou de production (14) au moyen d'un faisceau d'irradiation qui explore les articles transportés à une vitesse donnée dans un plan perpendiculaire à la direction d'acheminement, **caractérisé par** des moyens (18) aptes à mesurer une vitesse à laquelle ledit support d'articles est acheminé devant la source d'irradiation ou de rayonnement électromagnétique ; des moyens (18) aptes au traitement desdites mesures pour déterminer si ladite vitesse d'acheminement du support d'articles se situe à l'extérieur d'une plage donnée ; et des moyens (18) sensibles auxdits moyens de traitement pour interrompre à la fois l'irradiation provenant de la source d'irradiation et ledit acheminement par le convoyeur de traitement lorsque les moyens de traitement déterminent que la vitesse d'acheminement du support d'articles se situe à l'extérieur de ladite plage donnée.

8. Appareil pour système selon la revendication 7, **caractérisé en ce que** les moyens de mesure comprennent un élément (52) fixé sur chaque support d'articles présentant un bord crénelé (53) s'étendant en éloignement du support d'articles (17) ; et un interrupteur de fin de course (86, 86a) disposé par rapport au convoyeur de traitement ou de production (14) de façon à être actionné périodiquement par contact avec le bord crénelé dudit élément lorsqu'un support d'articles est en cours d'acheminement par le convoyeur de traitement devant la source d'irradiation ou rayonnement électromagnétique (10).

9. Appareil pour système selon la revendication 8, **caractérisé en ce que** les moyens de traitement (18) sont aptes à mesurer la fréquence dudit fonctionnement de l'interrupteur de fin de course (86, 86a) ; et les moyens sensibles (18) sont aptes à interrompre ladite irradiation et ledit acheminement lorsque ladite fréquence mesurée se situe à l'extérieur d'une plage de fréquence prédéterminée.

10. Appareil pour système selon la revendication 7, dans lequel le faisceau d'irradiation ou de rayonnement électromagnétique présente une largeur donnée dans la direction d'acheminement, **caractérisé par**

des moyens (18) pour reprendre ledit acheminement par le convoyeur et ladite irradiation à partir de ladite source d'irradiation (10) ; et

des moyens (76) pour commander ou réguler l'accélération et la vitesse d'acheminement par le convoyeur au moment de ladite reprise en fonction d'un taux d'élévation donné du niveau d'énergie de lecture ou exploration et de la largeur donnée dudit faisceau d'irradiation ou de rayonnement électromagnétique de telle sorte que la partie de l'article en cours de lecture ou d'exploration, au moment de l'interruption de l'irradiation et de l'acheminement, est lue ou explorée avec un dosage total d'irradiation antérieur et postérieur à l'interruption dans une plage de dosage prescrite.

FIG. 1

FIG. 2

FIG. 3A

FIG. 3B

FIG. 3C

FIG. 4

66 77 68

17

70

21

21

62 20

58

60

17

17

57

66 17

79 84

17

EP 0 746 870 B2

23

FIG. 5B

FIG. 5A

FIG. 6A

FIG. 6B

FIG. 7A

EP 0 746 870 B2

LOAD CONVEYOR SPEED

$T_R$  $T_v$  $T_D$  $T_m$  $T_L$

$S_L$

$A_R$  $T_C$  $A_M$

$S_P$

0

TIME

$t_o$

DISTANCE ARTICLE CARRIER TRANSPORTED BY LOAD CONVEYOR

$X_L$  $T_L$

$X_C$

0

TIME

$t_o$

FIG. 7B

FIG. 8A

FIG. 8B

FIG. 9

**EP 0 746 870 B2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3564241 A

- US 4852138 A